# EUROPEAN PATENT SPECIFICATION

(11) **EP 3 412 397 B1**
(45) Date of publication and mention of the grant of the patent: **18.11.2020**
(21) Application number: 17192036.6
(22) Date of filing: 20.09.2017
(51) Int. Cl.: B23K 11/00, B23K 11/31, B23K 11/30, B23K 11/25, B23K 11/11, G06F 30/00, G06F 30/20

(54) **METHOD OF PREDICTING WELDING SPATTERS DURING A RESISTANCE WELDING PROCESS**
VERFAHREN ZUR VORHERSAGE VON SCHWEISSSPRITZERN WÄHREND EINES WIDERSTANDSSCHWEISSVERFAHRENS
PROCÉDÉ DE PRÉDICTION DE PROJECTIONS DE SOUDURE AU COURS D'UN PROCESSUS DE SOUDAGE PAR RÉSISTANCE

(30) Priority: 06.06.2017 EP 17174471
(43) Date of publication of application: 12.12.2018
(73) Proprietor: Robert Bosch GmbH, 70442 Stuttgart (DE)
(72) Inventor: Court, Denis, 71404 Korb (DE); Hofinger, Simon, 10245 Berlin (DE); Schnadinger, Marc, 71640 Ludwigsburg (DE); Lukosz, Harald, 73614 Schorndorf (DE); Srinivasan, Soundarajan, MA 02032 USA (US); Reddick, Rachel, Mountain View, CA California CA 94040 (US)

(56) References cited:
- DE-A1-102013 216 966
- JP-A- 2007 283 328
- KR-A- 20120 032 119
- US-A- 5 834 729
- US-A1- 2017 032 281

## Description

### Field of the invention

The present invention relates to a method of predicting welding spatters during a resistance welding process.

### Background of the invention

For example, in automated body construction welding guns are employed as welding devices. After closing of the welding gun the welding process is usually carried out in time sections (lead time, current and pause times, hold time) that have been defined by the user.

A resistance welding device, with the possibility to control the welding parameters which influence the welding operation, in particular the welding current, the current time, and the electrode force is shown in EP 1414610 B1. It is referred thereto regarding basic technical details of welding devices according to the invention.

During the welding process droplets of molten metal (welding spatters) can erupt due to the extreme intensity of heat and power, which are applied at or near the weld joint. This leads to poorer welding quality and contamination of metal surfaces, in particular the workpiece surfaces and the surfaces of the welder itself, for example, its electrode caps. A spatter accumulation can cause undesirable results, which vary depending on the location of the accumulation. For example, welding spatters which cover the visible surfaces of the workpiece can create an unsightly, rough end surface; thereby additional time-consuming surface cleaning and welding spatter removal steps are required. An accumulation of weld spatters at the electrode caps can make necessary frequent milling or dressing steps and even changes.

It is known from DE 102013216966 A1 to monitor welding processes for an occurrence of welding spatter. For this purpose a resistance measurement is carried out. However, only spatter that has already occurred can be detected.

JP 2007 183328 A (basis for the preamble of claim 1) provides a resistance spot welding method that enables the prediction of the occurrence of spatters based on an electrode pressurizing force acting on an unmolten section of two workpieces which are in contact with each other.

KR 2012 0032119 A provides an intelligent welding control method to change welding conditions in the middle and late stages of welding according to needs, based on the welding quality predicted in the initial stage of welding, thereby improving welding quality.

US 5 834 729 A provides a method for adapting fuzzy reasoning to a change of a working environment of resistance welding without requiring a changing or updating membership functions, thereby assuring optimal control and satisfactory weld quality.

US 2017 032281 A1 provides a weld production knowledge system for processing welding data collected from one of a plurality of welding systems, the weld production knowledge system comprising a communication interface communicatively coupled with a plurality of welding systems situated at one or more physical locations. The communication interface may be configured to receive, from one of said plurality of welding systems, welding data associated with a weld.

### Disclosure of the Invention

According to the invention a method of predicting welding spatter in a resistance welding process with the features of claim 1 is proposed. Advantageous further developments form the subject matter of the dependent claims and of the subsequent description.

The invention is particularly suitable for resistance spot welding processes. Such methods can be controlled relatively precisely by means of welding controls (computing units, eg. programmable logic controllers, PLC), since the welding parameters which influence the welding process (in particular welding current, welding voltage, current time, ie. the time at which a welding current flows, and electrode force, with which the welding electrodes are pressed against the workpiece) can be controlled electronically sufficiently precisely.

The invention provides a simple but accurate method for predicting welding spatter which does not require additional auxiliary or measuring means. If an occurrence of welding spatter is predicted, it can advantageously be counter-controlled before the occurrence of the spatter.

The invention is based on the knowledge that the occurrence of welding spatter can be well predicted using so-called classification models (also called algorithms), in particular when these models have been trained based on the actual embodiment. Inputs to the model are, according to the present invention, information about the state of the electrode tips and at least one of the welding voltage and the welding current, such as, e.g. count values concerning the number of welding processes carried out with the electrode tips and/or the number of milling processes carried out to the electrode tips, and welding voltage and/or welding current profiles.

Using data recorded about the state of the tips used in welding and the current and voltage between them, it is possible to train a classification model to predict spatter prior to its occurrence. The training data advantageously comprises numerous sets of data associated with a weld.

When a trained model is run, it provides a score for each weld, describing how likely it is that a given weld will have spatter. For convenience, all of the scores can be normalized to range between 0 and 1, with 1 being more likely to have spatter. A threshold can then be chosen, so that all welds with a score higher than the threshold are labelled as spatter, and welds with a lower score are labelled good. This threshold predetermines the true positive rate (fraction of spatters that are prediction) and the false positive rate (fraction of good welds that are incorrectly labelled spatter).

Data especially relevant as input to the model according to the invention include at least one of the following:
- Tip Wear Count, indicating how many times the tip has been used (as a count value concerning the number of welding processes carried out with the electrode tips).
- Tip Dress Count, indicating how many times the tip has been dressed (milled) (as a count value concerning the number of milling processes carried out to the electrode tips).
- Time series measurements of voltage and current and processed data thereof.
- Reference time series for voltage and current, which are the same for all welds in one program, and describe how the weld is expected to proceed for good welds.

Preferably, the time series measurements of voltage and current comprise at most 500 ms, more preferably at most 400, 300, 200 or 100 ms after applying the welding current. Thus, according to the invention, welding spatter can be predicted very early in the process.

Preferably, the time series measurements of voltage and current are processed using curve sketching, eg. determining derivations, slopes etc.

Preferably, the time series measurements of voltage and current are processed using Haar wavelet transform. The Haar wavelet transform is a linear transformation of a time series which preserves all of the information of the original time series. The wavelet transformation can be computed in the following way:
Choosing the model well is also important, as it determines how future predictions are likely to behave and how much computation time is needed to produce a prediction. In cases where the true positive rate, our measure of quality, is not very different for some model types, it is best to use the simplest model. The model types that are considered most advantageous are based around three different algorithms:
- Logistic Regression (LR): Logistic Regression is a linear model. It searches for the plane in feature space which most effectively divides goods welds from bad welds. This is the simplest model.
- Support Vector Machine (SVM): Support Vector Machines (SVM) uses a non-linear kernel to transform the feature space, drawing a non-linear separation between regions of spatter and good welds.
- Random Forest (RF): A random forest combines a set of decisions trees that are trained on subsamples of the data. By combining many trees, the model avoids overfitting while allowing a potentially very nonlinear classification scheme.

If an occurrence of weld spatter is predicted, suitable countermeasures can be performed, eg. reducing welding voltage and/or reducing welding current and/or current time and/or increasing electrode force.

Further advantages and developments of the invention are specified in the description and the associated drawings.

The invention is illustrated schematically in the drawings on the basis of exemplary embodiments and will be described in detail in the following with reference to the drawings.

### Description of drawings

Fig. 1 shows an exemplary embodiment of a X-type welding gun.
Fig. 2 shows an example of a reference voltage profile and a measured voltage curve with a spatter in a current time.

### Detailed Description of the Drawing

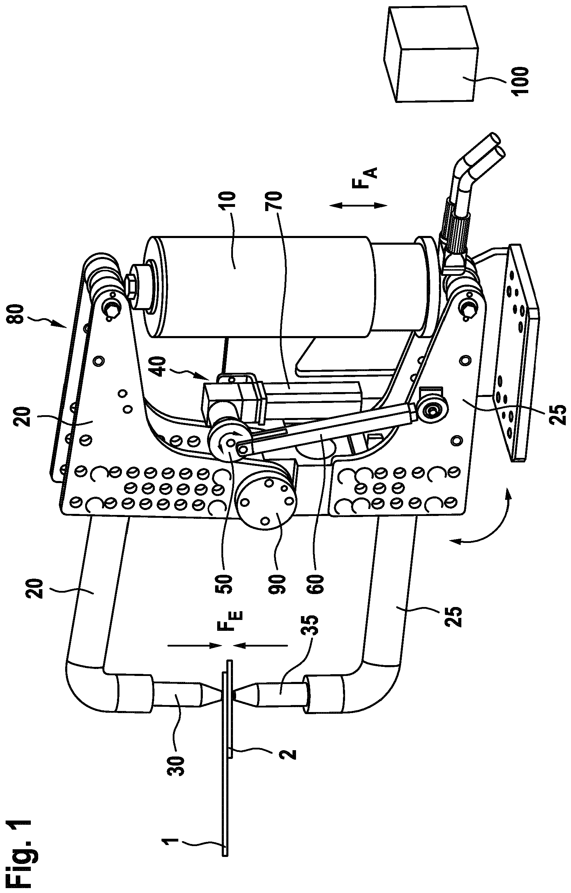

In Fig. 1, there is shown a resistance welding apparatus being designed as a X-type welding gun 80 having an axis of tilting 90, which has two welding gun legs 20, 25 each having a welding electrode 30, 35. As X-type welding guns welding guns are referred to, in which both welding gun legs are moved to open and close the welding gun. For the movement of the two legs 20, 25, an electrode drive 10 is present, which is usually designed as an electric motor, hydraulic motor or pneumatic motor and applies a driving force F_{A}. Welding guns are used for spot welding.

A workpiece to be welded, usually formed as two sheets 1, 2 as the joining members, is arranged between the welding electrodes 30, 35, whereupon the welding gun 80 is closed by means of the electrode drive 10 so that the welding electrodes 30, 35 clamp the workpiece with an electrode force F_{E}. Typical electrode forces are very high and vary in the range 1-10 kN. The electrode force can be determined from the driving force by the geometrical parameters of the welding gun, which driving force in turn can be measured or calculated from the drive current (in case of an electric motor 10). This is known in principle. Often a force sensor is located in the electrode drive or alternatively on the gun frame or gun leg.

After applying the electrode force, a welding current of several kiloamperes (kA) is passed through the welding spot using a welding transformer (not shown) as a welding current source having a welding voltage of usually <20 V at different frequencies. This causes the two joining members 1, 2 being heated due to the contact resistance in a punctiform manner to the melting temperature or slightly below so that the plastic and sometimes the liquid state of the joining members is achieved locally. The connection happens due to the electrode force F_{E}, with which the two joining members 1, 2 are pressed together at the contact spot; the materials in contact diffuse into each other.

Furthermore, the X-type welding gun 80 comprises in the shown embodiment a compensation device 40, which enables, in particular a central alignment of the two welding gun legs 20, 25 relative to the workpiece. The compensation device 40 has in the shown example a compensation device drive designed as a servomotor 70, a downforce designed as a driven pulley 50 and a power transmission means designed as a connecting rod 60. The compensation device is thus realized as a crank mechanism.

The X-type welding gun 80 is controlled by a welding controller (computing unit, eg. PLC) 100 in which a welding program is run and which controls the welding parameters influencing the welding process (in particular, welding current, current time and electrode force) in accordance with the welding program.

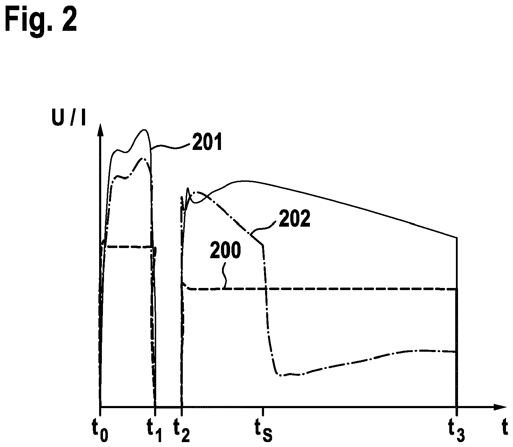

In a preferred embodiment of the invention, an electric voltage between the electrodes 30, 35 during the entire welding process is detected (with and without welding current supply). An exemplary voltage curve over time is shown in Fig. 2.

The current curve is denoted by 200 and can be divided into a first current time between t₀ and t₁, a pause time between t₁ and t₂ and a second current time between t₂ and t₃. The voltage curve for a faultless reference measurement is denoted with 201, and a faulty measurement with welding spatter is denoted with 202. In Fig. 2 it can be seen that shortly after t₂ the measurement curve 202 decreases first continuously and then approximately at t_{S} abruptly. This behavior is indicative of the occurrence of weld spatter at t_{S}.

In line with a preferred embodiment of the invention, it is possible to predict the occurrence of welding spatters, i.e. before they occur.

Firstly, a suitable model has to be chosen. As mentioned above, an advantageous model can be chosen from Logistic Regression (LR), Support Vector Machine (SVM), and Random Forest (RF). In a second step, the chosen model(s) has/have to be trained using multiple sets of data. Advantageously, multiple models are trained to see which model leads to the best predicting results for the given embodiment.

The training data advantageously comprise as many features as possible/suitable. As mentioned above, this advantageously includes tip wear count, tip dress count, features obtained by processing time series measurements of voltage and current, and/or features obtained by processing reference time series for voltage and current (see claim 1). Eg. the time series measurements of voltage and current comprise 100 ms after t₀, ie. after applying the welding current. In the given example, the features obtained by processing time series measurements of voltage and current are obtained by using derivations (eg. determining slopes) and Haar wavelet transform.

The Haar wavelet transformation can be computed in the following way:
1. The first element of the transform is the mean of the entire time series (eg. 0-100 ms).
2. The second element requires breaking the time series in half. The value is the difference between the mean of the first half (eg. 0-50 ms) of the time series and the second half (eg. 50-100 ms).
3. The next two elements (3 and 4) require breaking the time series into four pieces. Element 3 is the difference between the mean of the first quarter (eg. 0-25 ms) and the second quarter (eg. 25-50 ms), while element 4 is the difference between the third (eg. 50-75 ms) and fourth quarter (eg. 75-100 ms).
4. Continue breaking the time series into smaller and smaller pieces and taking differences, until single time series points are used. For a time series of eg. length 128, elements 65 through 128 are differences between pairs of individual time points.

The inventors have trained a number of models with 54 spots and associated data sets and determined the top 5 features which influence the prediction of the model. Of the 54 spots, at 100 ms, three do not have any features - too many spatters occurred prior to 100 ms for a model to be run, so no features are selected. Of the remaining 51 spots, 43 have tip wear count as one of the top 5 features, 38 have tip dress count, and 22 have the slope of the voltage in the first 10 ms. Thus, these three features are preferably used as inputs to the trained model.

The next two most common features are the mean of the voltage time series (Voltage Haar 1/128) and the difference between the voltage in the first half of the time series and the second half of the time series (Voltage Haar 2/128). The other features appear less frequently. Thus, these two features are optionally also used as inputs to the trained model.

Based on this result, a low tip wear count (a new tip, or newly dressed tip) is frequently associated with more spatter. A lower tip dress count is typically associated with a higher chance of spatter, but is generally a much weaker feature than tip wear count. A high early voltage slope and a high voltage in general (such as a high value in the mean, or the 1/128 Haar wavelet transform feature of the voltage) were also associated with a greater likelihood of spatter.

If spatter is predicted, the welding parameters for the current welding process can be adjusted accordingly to prevent the actual occurrence. Adjustments can be made in the welding current, the current time and the electrode force.

## Claims

1. Method of predicting welding spatters during a resistance welding process,
being **characterised in that**
a classification model is used to get a likelihood of a welding spatter will happen, wherein inputs to the model comprise
- information about a count value concerning the number of welding processes carried out with the electrode tips and/or a count value concerning the number of milling processes carried out to the electrode tips, and
- at least one of a time series measurement of the welding voltage and/or processed data thereof, and a time series measurement of the welding current and/or processed data thereof.

2. The method of claim 1, wherein the classification model is first trained based on parameters of the resistance welding process.

3. The method of claim 1, wherein the time series measurement comprises at most 500 ms, more preferably at most 400, 300, 200 or 100 ms after applying a welding current.

4. The method of any one of the preceding claims, wherein the time series measurement is processed using curve sketching and/or Haar wavelet transform.

5. The method of any one of the preceding claims, wherein the classification model comprises Logistic Regression, Support Vector Machine or Random Forest.

6. The method of any one of the preceding claims, wherein a countermeasure is performed, if an occurrence of weld spatter is predicted.

## Patentansprüche

1. Verfahren zum Vorhersagen von Schweißspritzern während eines Widerstandsschweißprozesses, das **dadurch gekennzeichnet ist, dass**
ein Klassifizierungsmodell verwendet wird, um eine Wahrscheinlichkeit zu erhalten, dass ein Schweißspritzer auftreten wird, wobei Eingaben in das Modell Folgendes umfassen:
- Informationen über einen Zählwert bezüglich der Anzahl an Schweißprozessen, die mit den Elektrodenspitzen ausgeführt wurden, und/oder einen Zählwert bezüglich der Anzahl an Fräsprozessen, die an den Elektrodenspitzen ausgeführt wurden, und
- eine Zeitreihenmessung der Schweißspannung und/oder verarbeiteter Daten davon und/oder eine Zeitreihenmessung des Schweißstroms und/oder verarbeiteter Daten davon.

2. Verfahren nach Anspruch 1, wobei das Klassifizierungsmodell zuerst basierend auf Parametern des Widerstandsschweißprozesses trainiert wird.

3. Verfahren nach Anspruch 1, wobei die Zeitreihenmessung höchstens 500 ms, bevorzugter höchstens 400, 300, 200 oder 100 ms nach dem Anlegen eines Schweißstroms umfasst.

4. Verfahren nach einem der vorhergehenden Ansprüche, wobei die Zeitreihenmessung unter Verwendung von Kurvendiskussion und/oder einer Haar-Wavelet-Transformation verarbeitet wird.

5. Verfahren nach einem der vorhergehenden Ansprüche, wobei das Klassifizierungsmodell logistische Regression, Support-Vector-Machine oder Random-Forest umfasst.

6. Verfahren nach einem der vorhergehenden Ansprüche, wobei eine Gegenmaßnahme durchgeführt wird, falls ein Auftreten eines Schweißspritzers vorhergesagt wird.

## Revendications

1. Procédé de prédiction d'éclaboussures de soudage durant un processus de soudage par résistance, **caractérisé en ce que**
un modèle de classification est utilisé pour obtenir une probabilité qu'une éclaboussure de soudage se produise, dans lequel des entrées dans le modèle comprennent
- des informations sur une valeur de compte concernant le nombre de processus de soudage réalisés avec les extrémités d'électrode et/ou une valeur de compte concernant le nombre de processus de fraisage réalisés sur les extrémités d'électrode, et
- au moins une d'une mesure de série chronologique de la tension de soudage et/ou de données traitées de celle-ci, et d'une mesure de série chronologique du courant de soudage et/ou de données traitées de celui-ci.

2. Procédé selon la revendication 1, dans lequel le modèle de classification fait premièrement l'objet d'un apprentissage sur la base de paramètres du processus de soudage par résistance.

3. Procédé selon la revendication 1, dans lequel la mesure de série chronologique comprend au plus 500 ms, mieux encore au plus 400, 300, 200 ou 100 ms après l'application d'un courant de soudage.

4. Procédé selon l'une quelconque des revendications précédentes, dans lequel la mesure de série chronologique est traitée en utilisant esquisse de courbe et/ou transformée en ondelette de Haar.

5. Procédé selon l'une quelconque des revendications précédentes, dans lequel le modèle de classification comprend : régression logistique, machine à vecteurs supports ou forêt aléatoire.

6. Procédé selon l'une quelconque des revendications précédentes, dans lequel une contre-mesure est réalisée, si une survenue d'éclaboussure de soudage est prédite.
